# EUROPÄISCHE PATENTSCHRIFT

(11) **EP 1 941 536 B1**
(45) Veröffentlichungstag und Bekanntmachung des Hinweises auf die Patenterteilung: **24.04.2019**
(21) Anmeldenummer: 05803461.2
(22) Anmeldetag: 26.10.2005
(51) Int. Cl.: H01L 21/67, H05K 13/04

(54) **VERFAHREN UND VORRICHTUNG ZUM ABLEGEN VON ELEKTRONISCHEN BAUTEILEN, INSBESONDERE HALBLEITERCHIPS, AUF EINEM SUBSTRAT**
METHOD AND DEVICE FOR THE PLACEMENT OF ELECTRONIC COMPONENTS, IN PARTICULAR SEMICONDUCTOR CHIPS, ON A SUBSTRATE
PROCÉDÉ ET DISPOSITIF POUR LA POSE D' ÉLÉMENTS ÉLECTRONIQUES, EN PARTICULIER DES PUCES SEMI-CONDUCTRICES, SUR UN SUBSTRAT

(43) Veröffentlichungstag der Anmeldung: 09.07.2008
(73) Patentinhaber: Kulicke & Soffa Die Bonding GmbH, 8572 Berg TG (CH)
(72) Erfinder: HERBST, Wolfgang, 78464 Konstanz (DE); TRINKS, Joachim, CH-9230 Flawil (CH); ERNST, Urban, 78464 Konstanz (DE); VAN MULKEN, Frans, CH-6277 Kleinwangen (CH)
(74) Vertreter: Körner, Thomas Ottmar
(86) Internationale Anmeldenummer: PCT/EP2005/055571
(87) Internationale Veröffentlichungsnummer: WO 2007/048445

(56) Entgegenhaltungen:
- WO-A1-97/32460
- DE-A1- 10 203 601
- DE-B3-102004 007 703
- US-A1- 2003 071 109
- US-A1- 2005 132 567
- PATENT ABSTRACTS OF JAPAN Bd. 2000, Nr. 20, 10. Juli 2001 (2001-07-10) -& JP 2001 060795 A (MATSUSHITA ELECTRIC IND CO LTD), 6. März 2001 (2001-03-06)

## Beschreibung

Die Erfindung betrifft ein Verfahren zum Ablegen von elektronischen Bauteilen, insbesondere Halbleiterchips, gemäss dem Oberbegriff von Anspruch 1. Mit einem derartigen Verfahren wird beispielsweise bei der Herstellung von Halbleiterbauteilen in Chipmontageautomaten (Diebondern) der ungehäuste Chip von der bereits unterteilten Siliziumscheibe (Wafer) gepickt und dann auf entsprechende Substrate abgelegt bzw. gebondet. Nach dem Bondprozess folgen weitere Prozessschritte wie z.B. Aushärten, Wirebonding, Aufschmelzen von Lötverbindungen, Verkapseln, Vereinzeln usw.

Für das Platzieren des Chips auf dem Substrat gibt es eine Vielzahl verschiedener Prozesse wie z.B. Kleben, Löten oder Laminieren. Die Art des Verbindungsprozesses bestimmt auch, ob der Chip vor der Platzierung gewendet werden muss (Flipchip-Anwendungen) oder nicht (Non-Flip-Anwendungen). Unter Wenden des Chips wird nachstehend ausdrücklich nicht eine Relativbewegung bezüglich einer Raumachse oder Raumebene verstanden, sondern ein Wenden in Bezug auf die ursprüngliche Auflageseite. Im Falle von Non-Flip-Anwendungen wird der Chip nicht gewendet, und nach der Aufnahme von der Waferfolie direkt in einem Schritt zum Substrat transportiert, wobei das Pickup-Werkzeug gleichzeitig auch als Bond-Werkzeug verwendet wird. Die Auflageseite, mit der der Chip auf der Waferfolie aufgeklebt war, ist dann auch die Seite, mit der der Chip auf das Substrat aufgeklebt wird. Eine bekannte Vorrichtung dieser Art ist beispielsweise in EP 1 049 140 B1 erwähnt oder durch die Firmenzeitschrift "Newsline 1/2002" der Anmelderin (Maschinentyp "Easyline") bekannt geworden. Im Falle von Flipchip-Anwendungen wird der Chip mit seiner Strukturseite nach dem Wenden auf das Substrat abgesetzt, d.h. die Auflageseite, mit der der Chip auf der Waferfolie aufgeklebt war, ist nach dem Platzieren dann die dem Substrat abgewandte Seite. An moderne Diebonder-Systeme werden immer grössere Anforderungen gestellt bezüglich Herstellungskosten, Durchsatz, Genauigkeit und Prozessflexibilität. Trotzdem sollten die Maschinen bezüglich Bauhöhe, Maschinengrundriss, Gewicht usw. bestehende Vorrichtungen nicht übertreffen. Dies führt zu einer immer grösseren Komplexität der Maschinen hinsichtlich Mechanik, Bewegungsabläufe und Steuerung.

Durch die US 2005/0132567 ist eine Vorrichtung bekannt geworden, bei welcher Halbleiterchips von einem drehbaren Pickwerkzeug aufgenommen werden und von dort auf eine höhere Ebene transportiert und von einem weiteren Werkzeug übernommen werden, das die Chips in einer linearen Bewegung über das Substrat führt und dort absetzt. Pickebene und Substratebene verlaufen parallel, jedoch auf unterschiedlichen Niveaus. Dadurch wird es möglich, dass der Wafertisch unter den Substrattisch gefahren werden kann, was ersichtlicherweise besonders bei grossen Wafern vorteilhaft ist, weil dadurch die Gesamtgrundfläche der Maschine klein gehalten werden kann. Allerdings wird hierbei der Chip durch die Übergabeoperation ersichtlicherweise gewendet, sodass er nicht mit seiner Auflageseite, sondern mit seiner Strukturseite auf das Substrat abgesetzt wird (Flipchip-Anwendungen).

Die DE 102 03 601 A betrifft unter anderem ein Verfahren zum Entnehmen von Chips von einem Wafer, bei welchem ein Entnahmewerkzeug und ein Wendewerkzeug jeweils drehbar ausgebildet ist und das Entnahmewerkzeug zum Entnehmen von Chips von einem Wafer verwendet wird. Die entnommenen Chips können entweder an einer ersten Übergabeposition in einem gewendeten Zustand an einen Bestückkopf übergeben werden oder von dem Entnahmewerkzeug an das Wendewerkzeug übergeben werden und von diesem in eine zweite Übergabeposition gedreht werden, wo sie in einem ungewendeten Zustand von einem Bestückkopf entnommen werden können.

Die JP 2001-060795 betrifft eine Montagevorrichtung für elektronische Teile, insbesondere für Chips. Diese werden von einem Transferkopf in einer bereits gewendeten Lage übernommen und zu einer Vorzentrierstation gefahren, wo Lageabweichungen mit einer Kamera festgestellt werden. Anschliessend werden die Chips in der gleichen gewendeten Lage von einem Montagekopf übernommen und abgelegt.

Die DE 10 2004 007 703 betrifft eine Vorrichtung und ein Verfahren zum Überprüfen und Umdrehen elektronischer Bauelemente, insbesondere Flipchips. Das Umdrehen der elektronischen Bauelemente erfolgt an einem drehbar gelagerten Bauteil, mit einem ersten Aufnahmeelement und mit einem diametral gegenüberliegenden zweiten Aufnahmeelement. Die Flipchips werden von einem Träger aufgenommen, um jeweils 180° gedreht und einer Ablegeeinrichtung übergeben.

Die WO 97/32460 betrifft ein Verfahren und eine Vorrichtung zum Aufnehmen, Orientieren und Montieren von Bauelementen, wie z. B. Chips. Mit Hilfe einer Transfereinheit werden die Chips von einer Aufnahmeebene abgenommen und zu einer Abgabeebene transportiert, wobei der Zustellweg in zwei Arbeitstakten zurückgelegt wird. Jeder Chip wird an einer im Bereich des Zustellwegs angeordneten Zwischenstation abgesetzt und dort wahlweise geschwenkt oder gedreht. Dadurch kann ein Chip mit dem Absetzkopf der Transfereinheit an seiner Unterseite angefasst und in gewendetem Zustand abgesetzt werden.

Es ist daher eine Aufgabe der Erfindung, ein Verfahren der eingangs genannten Art zu schaffen, bei welchem Bauteile auch mit der gleichen Auflageseite wieder auf das Substrat abgesetzt werden können (Non-Flip-Anwendung), wobei ein möglichst hoher Durchsatz mit einer verbesserten Absetzgenauigkeit erzielbar ist. Es soll ausserdem die Möglichkeit bestehen, bei Raumtemperatur zu picken, aber unter Umständen auch heiss platzieren zu können. Ausserdem soll es mit der gleichen Vorrichtung möglich sein, sowohl Flipchip- als auch Non-Flip-Anwendungen zu fahren, um das Einsatzspektrum mit geringen Mehrkosten erheblich zu verbreitern. Schliesslich soll die Vorrichtung möglichst kompakt aufgebaut sein und einen möglichst kleinen Maschinengrundriss aufweisen. Diese Aufgabe wird in verfahrensmässiger Hinsicht mit einem Verfahren gelöst, das die Merkmale im Anspruch 1 aufweist. In vorrichtungsmässiger Hinsicht wird die Aufgabe mit einer Vorrichtung gelöst, welche die Merkmale im Anspruch 5 aufweist.

Der Einsatz der Wendevorrichtung in der Bereitstellungsebene ermöglicht es auf einfache Weise den sonst bei der Übergabe des Bauteils vom Primärwerkzeug zum Sekundärwerkzeug stattfindenden Wendeprozess wieder rückgängig zu machen. Ersichtlicherweise erfüllt die Wendevorrichtung gleichzeitig die Funktion einer Art Zwischenstation, welche eine grössere Flexibilität bei den verschiedenen Bewegungsabläufen und Prozessparameter ermöglicht.

Weitere Vorteile können erreicht werden, wenn die Ist-Lage (Position und Winkel) des Bauteils auf der Vorratsstation vor der Aufnahme mit einer ersten Überwachungseinrichtung ermittelt wird, und/oder wenn die Ist-Lage des Bauteils in der Bereitstellungsebene vor dem Transport zum Substrat mit einer zweiten Überwachungseinrichtung ermittelt wird, und/oder wenn die Ist-Lage des Substrats mit einer dritten Überwachungseinrichtung ermittelt wird, wobei Abweichungen zwischen den ermittelten Ist-Werten und einer vorbestimmten Soll-Lage des Bauteils vorzugsweise während des Transports korrigiert werden. Bei den Überwachungseinrichtungen kann es sich dabei um Bilderkennungseinrichtungen, also beispielsweise um CCD-Kameras handeln. Mit insgesamt nur drei solcher Kameras lässt sich dabei eine sehr hohe Präzision bzw. eine optimale Korrekturmöglichkeit erreichen. Je nach Anwendungsfall wäre es aber auch denkbar, beispielsweise lediglich die Ist-Lage des Bauteils in der Bereitstellungsebene bzw. an der Wendevorrichtung zu vermessen.

Die Ermittlung der Ist-Lage erfolgt vorteilhaft immer dann, wenn das Primärwerkzeug bzw. das Sekundärwerkzeug das Bildfeld der zu ermittelnden Ist-Lage freigibt. Transportbewegung und Bilderkennung laufen somit parallel nebeneinander, ohne sich gegenseitig zu behindern.

Ein besonders hoher Bauteildurchsatz wird erreicht, wenn ein erstes und ein zweites Primärwerkzeug derart betätigt werden, dass das erste Primärwerkzeug ein Bauteil an der Vorratsstation aufnimmt, während das zweite Primärwerkzeug ein Bauteil an die Wendevorrichtung abgibt. Die beiden Primärwerkzeuge können sich bezüglich Aufnahme und Abgabe der Bauteile dabei synchron oder asynchron bewegen.

Wenn die dritte Bilderkennungseinrichtung für das Erkennen der Ist-Lage des Substrats an einem verschiebbaren Schlitten gelagert ist, kann die dritte Bilderkennungseinrichtung unabhängig von der jeweiligen Stellung des Sekundärwerkzeugs in eine Beobachtungsposition gefahren werden. Dies vereinfacht die Konstruktion der Substratzuführung. Bei Substraten mit matrixartiger Anordnung von Absetzpositionen müssen die Substrate nämlich nur in einer Richtung (X) verschoben werden, während die andere Richtung (Y) von der in dieser Raumrichtung bewegbaren dritten Bilderkennungseinrichtung und dem ebenso in dieser Raumrichtung bewegbaren Sekundärwerkzeug erreichbar ist. Zudem erhöht dies ersichtlicherweise die Flexibilität der Abläufe und verbessert so den Durchsatz, da die Messung entkoppelt von der Position des Sekundärwerkzeugs erfolgen kann und damit Prozesse parallelisiert werden können.

Weitere Vorteile können erreicht werden, wenn die erste und zweite Bilderkennungseinrichtung derart angeordnet sind, dass die Erfassung der ihnen zugeordneten Bildfelder von innerhalb des Drehkreises des Primärwerkzeugs aus erfolgt. So kann gleichzeitig eine Bilderkennungseinrichtung von oben auf die Vorratsstation gerichtet sein, während eine weitere Bilderkennungseinrichtung von unten auf das entweder durch das Sekundärwerkzeug oder durch die Wendevorrichtung gehaltene Bauteil gerichtet ist.

Begünstigt wird diese Art der Beobachtung der Bildfelder dadurch, dass ein erstes und ein zweites Primärwerkzeug einander bezogen auf die Drehachse vorzugsweise an einem U-förmigen Dreharm diametral gegenüberliegend angeordnet sind.

Auch die Wendevorrichtung selbst kann ein drehbares Doppelarmwerkzeug sein, wobei mit jedem Arm ein Bauteil in der Bereitstellungsebene vom Primärwerkzeug übernehmbar bzw. an das Sekundärwerkzeug übergebbar ist.

Das Sekundärwerkzeug ist vorteilhaft an einem linear verschiebbaren Schlitten angeordnet. Denkbar wären aber auch kurvenförmige Bewegungen oder ebenfalls eine Drehbewegung.

Eine besonders Platz sparende und kinematisch vorteilhafte Anordnung ergibt sich, wenn das Primärwerkzeug sich auf einer Drehebene dreht, welche etwa parallel zur Verschieberichtung des Sekundärwerkzeugs verläuft. Bei dieser Anordnung erstrecken sich nämlich die Gehäuse für Antrieb und Kameraaufbauten innerhalb des Drehkreises quer zur Verschieberichtung des Sekundärwerkzeugs, was sich auf den Maschinengrundriss vorteilhaft auswirkt.

Weitere Vorteile können erreicht werden, wenn die Ablagestation als Transportstation für den vorzugsweise linearen Durchlauf einer Mehrzahl von Substraten ausgebildet ist. Als Transportmittel können dabei an sich bekannte Klemmeinrichtungen, Förderbänder oder dergleichen eingesetzt werden.

Eine diskontinuierliche Zufuhr von Bauteilen an der Vorratsstation kann besonders vorteilhaft dadurch erreicht werden, dass die Wendevorrichtung als Pufferstation für die vorübergehende Aufnahme einer Mehrzahl von Bauteilen ausgebildet ist. So wäre es beispielsweise denkbar, die Wendevorrichtung als Karussell mit einer Mehrzahl von Wendestellen auszubilden, sodass stets ein bestimmter Vorrat von Bauteilen an die Pufferstation aufgenommen wird. Dadurch ist es möglich, beispielsweise für die Zufuhr eines neuen Waferframes an der Vorratsstation das Primärwerkzeug vorübergehend stillzusetzen. Während dieser Stillstandszeit entnimmt das Sekundärwerkzeug die Bauteile von der Pufferstation.

Neben der Vorratsstation kann eine Waferkassette angeordnet sein, welche zum Laden von Waferframes auf die Vorratsstation in verschiedene Ladepositionen bewegbar ist, in denen die Vorratsstation und die Waferkassette wenigstens teilweise auf der gleichen Ebene angeordnet sind, wobei die Waferkassette in eine Ruheposition bewegbar ist, in welcher die Vorratsstation zum Abarbeiten eines geladenen Waferframes wenigstens teilweise in der horizontalen Arbeitsebene über die Waferkassette verschiebbar ist. Ersichtlicherweise kann so die Waferkassette sehr Platz sparend angeordnet werden, ohne dass ihre Funktion beim Beladen der Arbeitsstation beeinträchtigt wird.

Weitere Vorteile können schliesslich auch noch erreicht werden, wenn im Bereich des Drehkreises des Primärwerkzeuges eine oder mehrere Zwischenablagestationen angeordnet sind, an denen ein Bauteil vor der Übergabe an die Wendevorrichtung bzw. vor der Übergabe an das Sekundärwerkzeug vorübergehend ablegbar ist. Ersichtlicherweise können so einzelne Bauteile vorübergehend aus dem Arbeitsprozess ausgeschieden und zwischengelagert werden, um zu einem späteren Zeitpunkt wieder weiter verarbeitet zu werden. Im Hinblick auf die heutigen Qualitätsanforderungen bei der Fertigung ist es nämlich teilweise erforderlich, beispielsweise Chips qualitätsmässig zu differenzieren. Um eine möglichst hohe Ausbeute zu erhalten, kann es erforderlich sein, dass nur qualitativ hochwertige Chips auf qualitativ hochwertige Substratpositionen abgesetzt werden, wobei qualitativ schlechtere Chips auf qualitativ schlechteren Substratpositionen eingesetzt werden können. Die Zwischenablagestation ermöglicht auf besonders einfache Weise auch eine qualitative Steuerung des Ablageprozesses.

Weitere Einzelmerkmale und Vorteile der Erfindung ergeben sich aus der nachfolgenden Beschreibung eines Ausführungsbeispiels und aus den Zeichnungen. Es zeigen:
- Figur 1: eine vereinfachte Darstellung eines unterteilten Wafers mit einem vergrössert dargestellten Halbleiterchip,
- Figur 2: eine stark schematisierte Darstellung einer erfindungsgemässen Vorrichtung von der Seite aus gesehen,
- Figur 2a: eine stark vereinfachte Seitendarstellung einer Vorrichtung mit einer Waferkassette in der untersten Zufuhrstellung,
- Figur 2b: die Vorrichtung gemäss Figur 2a mit der Waferkassette in der obersten Zufuhrstellung,
- Figur 2c: die Vorrichtung gemäss Figur 2a mit der Waferkassette in Ruhestellung,
- Figur 2d: die Seitendarstellung einer alternativen Vorrichtung mit einer zusätzlichen Zwischenablagestation im Bereich des Primärwerkzeugs,
- Figur 3: eine perspektivische Darstellung eines ersten und zweiten Primärwerkzeugs, einer Wendevorrichtung und eines Sekundärwerkzeugs,
- Figur 4: ein Querschnitt durch ein erstes und zweites Primärwerkzeug und ein Sekundärwerkzeug,
- Figur 5: die schematische Darstellung eines ersten und zweiten Primärwerkzeugs und einer Wendevorrichtung von der Seite gesehen,
- Figur 6a: ein Querschnitt durch ein erstes und zweites Primärwerkzeug mit den zugehörigen getrennten Bilderkennungseinrichtungen, für Ansicht nach unten und Ansicht nach oben,
- Figur 6b: ein Querschnitt durch ein erstes und zweites Primärwerkzeug mit einer zugehörigen gemeinsamen Bilderkennungseinrichtung für Ansicht nach unten und Ansicht nach oben,
- Figur 7a: verschiedene Sequenzen eines Arbeitsvorgangs mit Wenden
- Bis 7e: des Bauteils,
- Figur 8a: verschiedene Sequenzen eines Arbeitsvorgangs ohne Wen-
- bis 8e: den des Bauteils, und
- Figur 9: eine perspektivische Gesamtdarstellung einer Vorrichtung.

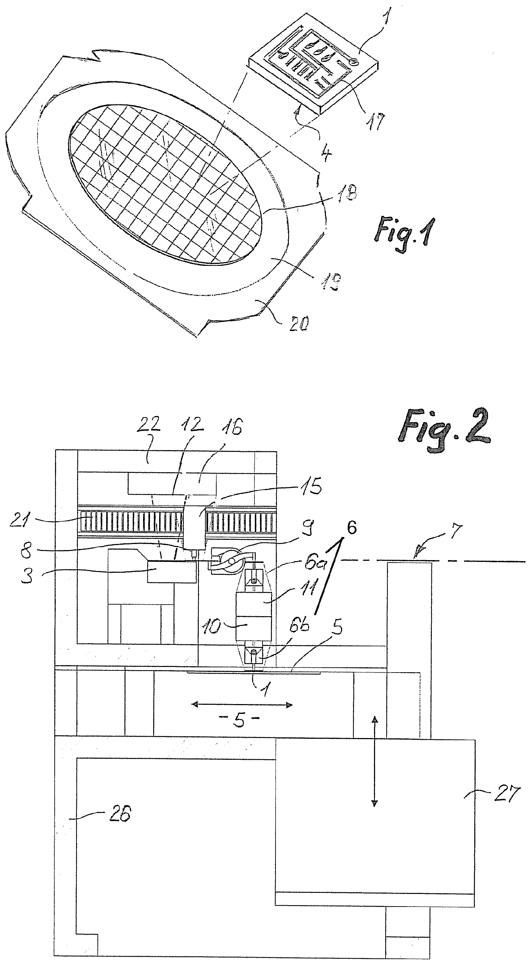

In Figur 1 ist stark vereinfacht eine an sich bekannte Anordnung dargestellt, bei welcher ein bereits unterteilter Halbleiterwafer 18 auf eine Waferfolie 19 geklebt ist, die ihrerseits in einem Waferframe 20 gespannt ist. Die Halbleiterchips oder einfach Chips 1 sind bereits durch die Sägelinien vereinzelt, was durch die sich kreuzenden Linien angedeutet ist. Jeder Chip 1 verfügt über eine Auflageseite 4, mit welcher er vor dem Ablösen auf der Waferfolie 19 haftet. Auf der der Auflageseite 4 gegenüberliegenden Seite ist eine Halbleiterstruktur aufgebracht, weshalb sie nachstehend als Strukturseite 17 bezeichnet wird. Das Vereinzeln der Chips durch Sägen bzw. der Ablösevorgang von der Waferfolie mit Hilfe von Nadeln und anderen Hilfsmitteln sind dem Fachmann bereits hinreichend bekannt.

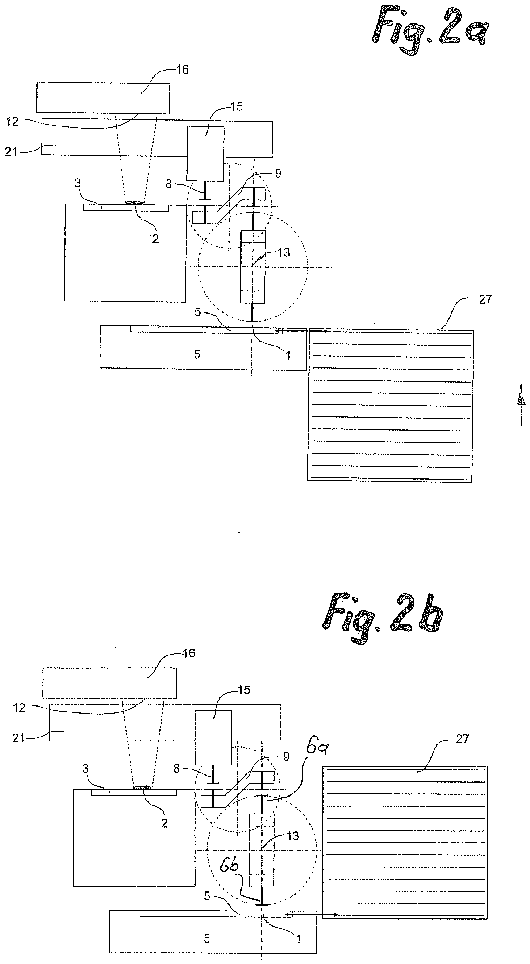

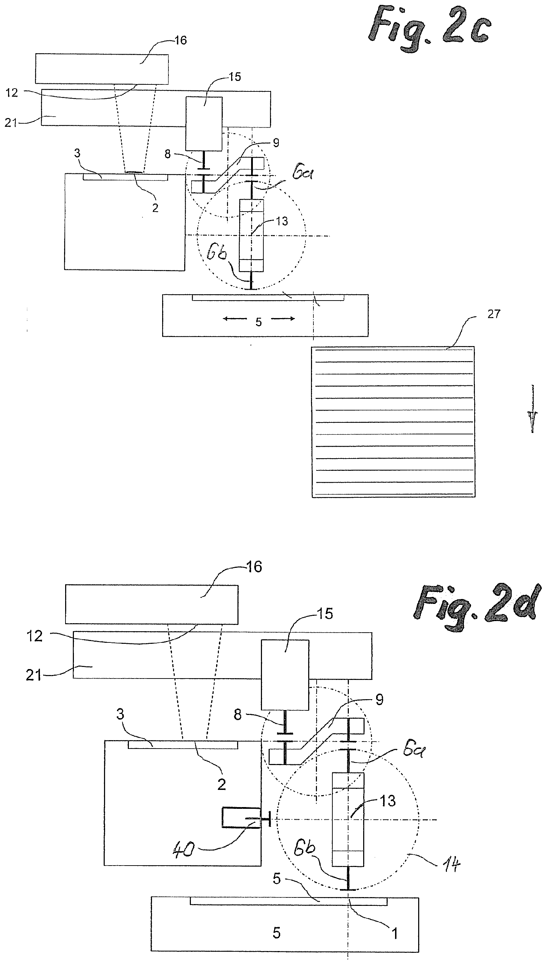

Zunächst werden anhand von Figur 2 die wichtigsten Maschinenkomponenten beschrieben. Auf einem Maschinengestell 26 ist eine Vorratsstation 5 angeordnet, welche im vorliegenden Fall als Wafertisch für die Aufnahme von vorbereiteten Waferframes gemäss Figur 1 ausgebildet ist. Aus einer Waferkassette 27 können bei Bedarf weitere Waferframes nachgeschoben werden. Über der Vorratsstation 5 sind ein erstes und ein zweites Primärwerkzeug 6a, 6b eines Primärwerkzeugs 6 um eine Drehachse drehbar gelagert, was nachstehend noch genauer beschrieben wird. Mit Hilfe der beiden Primärwerkzeuge lassen sich die Halbleiterchips aus der Ebene der Vorratsstation 5 auf eine höher gelegene Bereitstellungsebene 7 transportieren.

Im Bereich dieser Bereitstellungsebene 7 ist eine Wendevorrichtung 9 angeordnet, welche in der Lage ist, einen Halbleiterchip von einem Primärwerkzeug zu übernehmen, um 180° zu wenden und einem Sekundärwerkzeug 8 zu übergeben. Das Sekundärwerkzeug 8 ist an einem ersten Schlitten 15 angeordnet, der entlang einer ersten Führungsschiene 21 verschiebbar ist.

In einem Bereich unter der Führungsschiene 21 und seitlich versetzt zur Vorratsstation 5 ist eine Ablagestation 3 angeordnet, die im vorliegenden Fall als Zufuhrsystemen für den Durchlauf einzelner Substrate 2 oder eines endlosen Substrats ausgebildet ist.

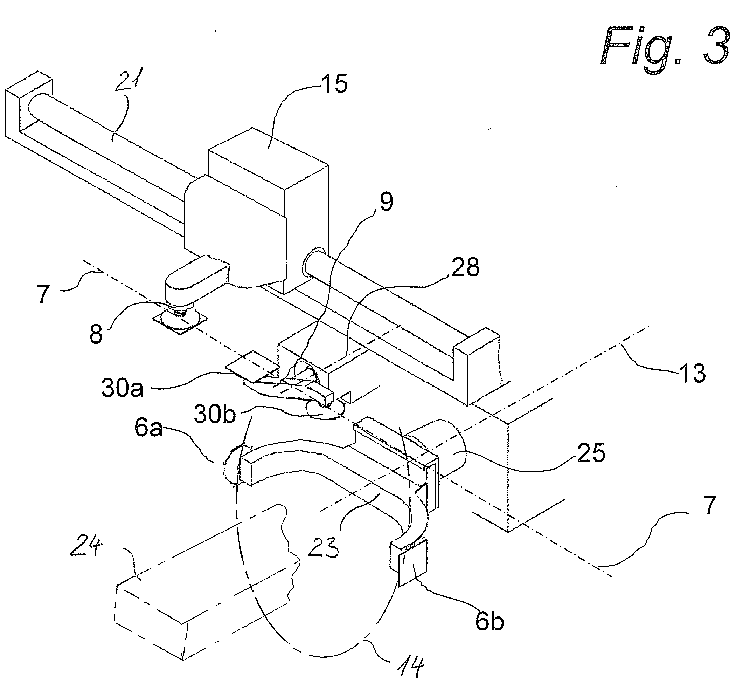

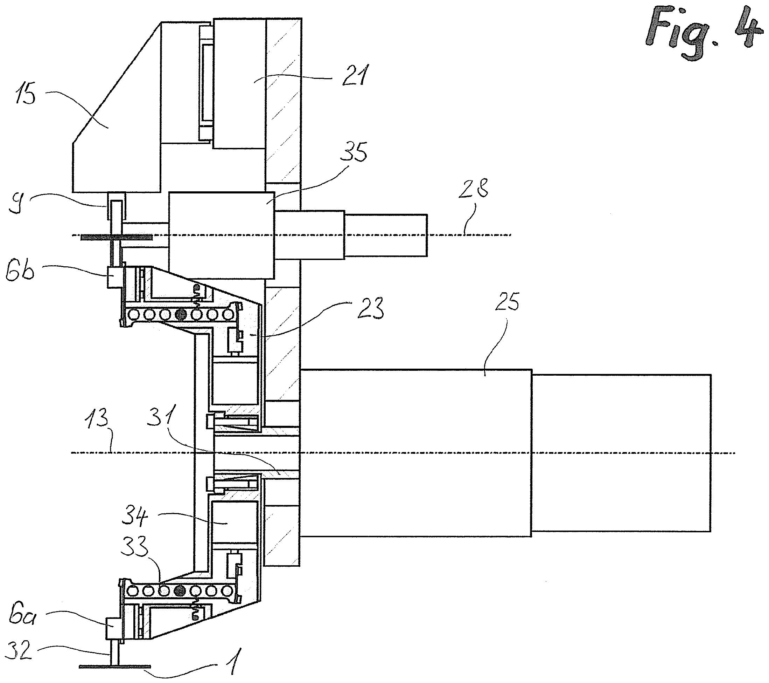

Für die Überwachung und Korrektur verschiedener Ist-Lagen sind verschiedene Kameras an der Vorrichtung angeordnet. Eine erste Kamera 10 ermittelt die Ist-Lage eines Chips 1 an der Vorratsstation 5 vor dem Abheben. Eine zweite Kamera 11 erkennt die Ist-Lage eines Halbleiterchips an der Wendevorrichtung 9 nach der Übergabe von einem ersten bzw. zweiten Primärwerkzeug 6a, 6b. Schliesslich vermag eine dritte Kamera 12 die Ist-Lage des Substrats 2 auf der Ablagestation 3 zu erkennen. Diese dritte Kamera 12 ist an einem zweiten Schlitten 16 angeordnet, der entlang einer zweiten Führungsschiene 22 verschiebbar ist. Weitere Einzelheiten zu diesen Komponenten ergeben sich auch noch aus den Figuren 3 und 4.

Da die Ablagestation 3 und die Vorratsstation 5 auf unterschiedlichen Ebenen liegen, lässt sich ersichtlicherweise die Vorratsstation 5, also der Wafertisch im Hinblick auf seinen Bewegungsbereich unter die Ablagestation also unter das Zufuhrsystem schieben, womit der Grundriss des Maschinengestells 26 sehr klein gehalten werden kann. Die Vorratsstation 5 muss in zwei Raumachsen horizontal verschiebbar sein, da jeder einzelne abzuhebende Chip jeweils exakt unter das abhebende Primärwerkzeug zu fahren ist. Derartige Steuerungen sind dem Fachmann bereits bekannt.

Aus den Figuren 2a bis 2c sind weitere Einzelheiten zur Verschiebbarkeit der Vorratsstation 5 ersichtlich und zwar auch in Kombination mit der Waferkassette 27. Die Waferkassette 27 verfügt auf an sich bekannte Weise über verschiedene Einschubfächer, wobei in jedem Fach ein vorbereiteter Waferframe mit unterteiltem Wafer (gemäss Figur 1) enthalten ist. Die Waferkassette ist vertikal bewegbar und ein hier nicht näher dargestellter Entnahmemechanismus kann aus jeder Etage einen Waferframe entnehmen und auf die Vorratsstation 5 transferieren. Gemäss Figur 2a steht die Waferkassette 27 in der untersten Entladeposition, in welcher aus der obersten Etage ein Waferframe entnommen werden kann.

In der Folge wird jedes Mal, wenn ein Waferframe leer gepickt ist, dieser in die entsprechende leere Etage zurückgeschoben und aus der nächsten Etage ein neuer Waferframe entnommen, bis die letzte Etage erreicht ist. Dabei befindet sich die Waferkassette 27 in der obersten Entnahmeposition, was in Figur 2b dargestellt ist. Wie aus dieser Figur besonders deutlich hervorgeht, verläuft die in der Abbildung linke Stirnseite der Waferkassette annähernd tangential zum Wendekreis der beiden ersten und zweiten Primärwerkzeuge 6a, 6b. Es wäre unter Umständen denkbar, die Waferkassette noch näher an die erste Drehachse 13 der beiden Primärwerkzeuge heran zu schieben, sodass ein Hochfahren der Waferkassette nur in der dargestellten Vertikallage der beiden Primärwerkzeuge möglich wäre.

Beim Abpicken eines Waferframes auf der Vorratsstation 5 wird die Waferkassette 27 unter das Niveau der Vorratsstation abgesenkt, was in Figur 2c dargestellt ist. In dieser Position kann die in zwei Raumachsen verschiebbare Vorratsstation 5 sowohl unter die Ablagestation 3 als auch über die Waferkassette 27 geschoben werden, womit ersichtlicherweise der Maschinengrundriss sehr klein gehalten werden kann.

Die Figur 2d zeigt eine alternative Ausführungsform einer Vorrichtung gemäss Figur 2 mit einer zusätzlichen Zwischenablagestation 40 im Bereich des Drehkreises 14 der beiden ersten und zweiten Primärwerkzeuge 6a, 6b. Mehrere derartige Zwischenablagestationen könnten winkelmässig verteilt im Bereich des Drehkreises 14 angeordnet sein. Die Zwischenablagestation hat eine Pufferfunktion und dient dazu, einen abgepickten Chip zwischen zu lagern. Zu einem späteren Zeitpunkt kann dieser Chip wieder in den Arbeitsprozess integriert oder aber ganz ausgeschieden werden.

Figur 3 zeigt weitere Einzelheiten des Primärwerkzeugs und des Sekundärwerkzeugs. Die beiden ersten und zweiten Primärwerkzeuge 6a, 6b sind am Ende und auf der Aussenseite eines U-förmigen Dreharms 23 einander diametral gegenüberliegend angeordnet. Der Dreharm dreht sich um eine horizontale erste Drehachse 13 und ist über einen Motor 25 drehantreibbar. Die beiden ersten und zweiten Werkzeuge 6a, 6b beschreiben dabei einen Drehkreis 14. Ein nachstehend noch beschriebenes Kameragehäuse 24 mit Objektivausgängen ist innerhalb des Drehkreises 14 angeordnet.

Die Bereitstellungsebene 7 bildet praktisch eine horizontale Tangente zum Drehkreis 14. In dieser Bereitstellungsebene ist die Wendevorrichtung 9 mit ersten und zweiten Wendearmen 30a, 30b angeordnet. Ihre zweite Drehachse 28 ist seitlich etwas versetzt zur ersten Drehachse 13 des Dreharms 23. An jedem Ende eines ersten und zweiten Wendearms 30a, 30b ist analog zu den beiden ersten und zweiten Primärwerkzeugen 6a, 6b eine Vorrichtung zum Festhalten eines Halbleiterchips, beispielsweise eine Saugnadel angeordnet.

Über der Bereitstellungsebene 7 erstreckt sich die erste Führungsschiene 21 für den ersten Schlitten 15 des Sekundärwerkzeugs 8. In der in Figur 3 dargestellten Position hat das Sekundärwerkzeug 8 gerade einen Halbleiterchip vom zweiten Wendearm 30b der Wendevorrichtung 9 übernommen und transportiert diesen gegen die Ablagestation. Der zweite Wendearm 30b ist schon wieder bereit für die Übernahme eines neuen Chips vom zweiten Primärwerkzeug 6b.

Gemäss Figur 4 ist der Dreharm 23 mit den beiden ersten und zweiten Primärwerkzeugen 6a, 6b auf einer Welle 31 angeordnet. Die Primärwerkzeuge bestehen beispielsweise aus einer Saugnadel 32, welche einen Halbleiterchip 1 ansaugen kann. Für die Abnahme von der Waferfolie muss ersichtlicherweie eine geringe Hubbewegung zurückgelegt werden können. Diese Hubbewegung erfolgt hier dadurch, dass die Saugnadel 32 am Ende eines schwenkbaren Doppelhebelarms 33 angeordnet ist. Das andere Ende ist mit einem Pneumatikkolben 34 verbunden, bei dessen Betätigung sich auch die Saugnadel 32 verschiebt. Anstelle des Pneumatikkolbens könnte beispielsweise auch eine elektromagnetische Antriebsvorrichtung eingesetzt werden. Die Realisierung der Hubbewegung könnte selbstverständlich auch noch über andere Mittel erreicht werden.

Aus Figur 4 ist auch ersichtlich, dass die Wendevorrichtung 9 über einen eigenen Antriebsmotor 35 verfügt.

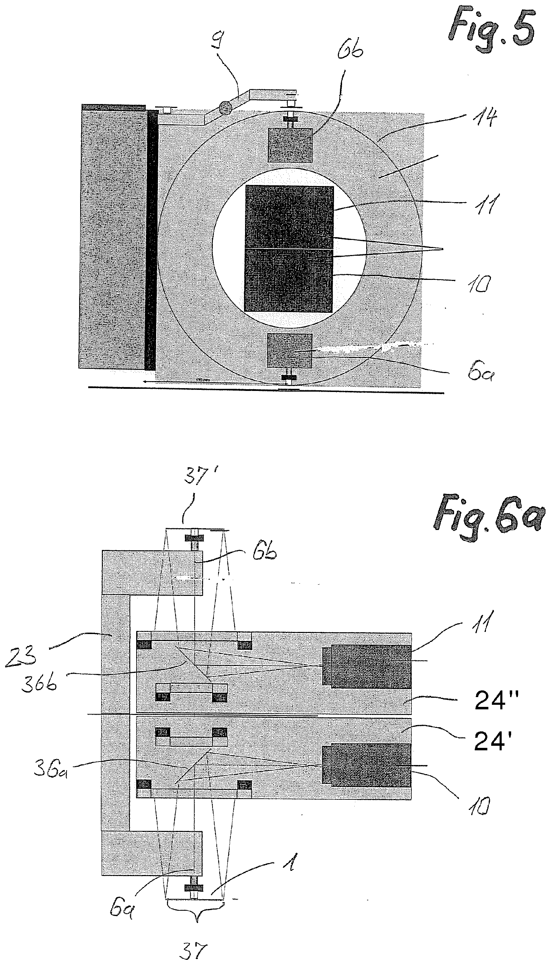

Die Figuren 5 und 6a zeigen schematisch die Anordnung der beiden ersten und zweiten Kameras 10 und 11 mit der dazugehörigen Beleuchtungseinheit innerhalb des Drehkreises 14 für die beiden ersten und zweiten Primärwerkzeuge 6a, 6b. Die beiden ersten und zweiten Kameras 10 und 11 sind in separaten ersten und zweiten Kameragehäusen 24', 24" übereinander angeordnet und zwar auf einer vertikalen Ebene, welche um 90° versetzt zur vertikalen Ebene des Drehkreises 14 verläuft. Die ersten und zweiten Bildbereiche 37, 37' der zu erfassenden Ist-Lagen werden über erste und zweite Umlenkspiegel 36a, 36b betrachtet. Der erste Umlenkspiegel 36a ist der ersten Kamera 10 zugeordnet und erfasst den ersten Bildbereich 37 auf der Vorratsstation 5, während der zweite Umlenkspiegel 36b der zweiten Kamera 11 zugeordnet ist und damit von unten her den zweiten Bildbereich 37' eines von der Wendevorrichtung 9 oder gegebenenfalls vom Sekundärwerkzeug festgehaltenen Halbleiterchips betrachtet. Selbstverständlich sind auch entsprechende Lichtquellen vorgesehen, welche die zu betrachtenden Bildbereiche beleuchten.

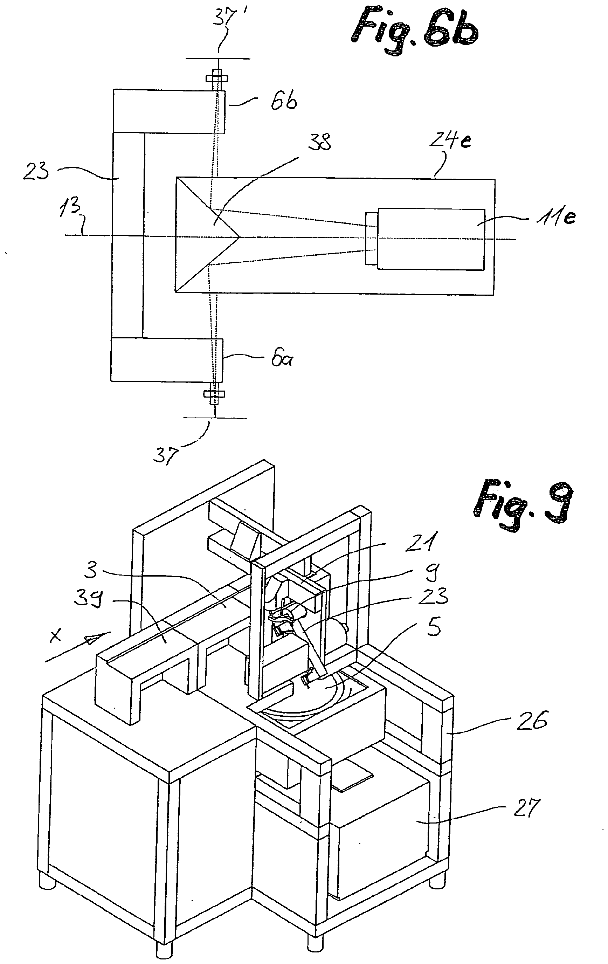

Im Gegensatz dazu zeigt die Figur 6b eine alternative Ausführungsform, bei welcher die beiden ersten und zweiten Bildbereiche 37, 37' mit einer einzigen Kamera 11e betrachtet werden, welche in einem Kameragehäuse 24e untergebracht ist. Das Kameragehäuse erstreckt sich dabei in Längsrichtung der ersten Drehachse 13 des Dreharms 23. Die bei dieser Lösung erforderliche Bildaufteilung erfolgt beispielsweise über einen Spiegel 38.

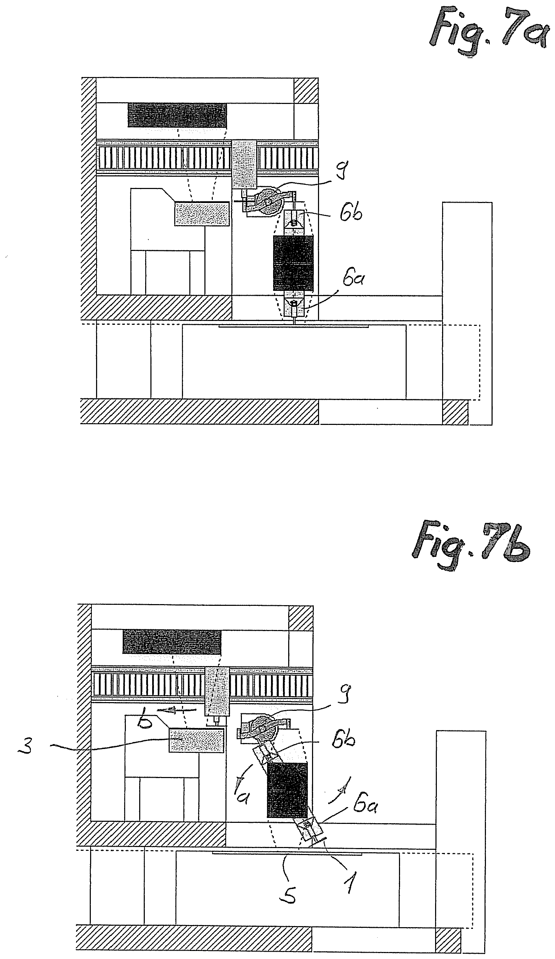

Nachstehend wird anhand der Figuren 7a bis 7e der Ablegevorgang eines Halbleiterchips beschrieben, bei dem der Chip mit der gleichen Auflageseite auf das Substrat abgelegt wird, mit der er vorher auf der Waferfolie haftete (Non-Flip-Anwendung). Gemäss Figur 7a steht der Dreharm 23 in einer vertikalen Position, in welcher das erste Primärwerkzeug 6a einen Halbleiterchip von der Vorratsstation 5 erfasst und das zweite Primärwerkzeug 6b einen bereits vorher aufgenommenen Halbleiterchip an die Wendevorrichtung 9 übergibt.

Gemäss Figur 7b dreht sich der Dreharm 23 in Pfeilrichtung a und der Schlitten mit dem Sekundärwerkzeug 8 bewegt sich in Pfeilrichtung b. Das Sekundärwerkzeug hat dabei von der Wendevorrichtung einen Halbleiterchip übernommen, während der vorher an die Wendevorrichtung abgegebene Halbleiterchip immer noch in der gleichen Position verharrt. Das zweite Primärwerkzeug 6b bewegt sich jetzt ohne Ladung nach unten, während das erste Primärwerkzeug 6a sich mit einem aufgenommenen Halbleiterchip nach oben bewegt. In der dargestellten Position sind die Bildbereiche für die zu erfassenden Ist-Lage nicht mehr durch die beiden ersten und zweiten Primärwerkzeuge 6a, 6b verdeckt, so dass jetzt wie in Figur 6a dargestellt die Erfassung der Ist-Lage eines neuen Halbleiterchips auf der Vorratsstation sowie diejenige des immer noch an der Wendevorrichtung festgehaltenen Halbleiterchips erfolgen kann. Etwa gleichzeitig erfasst die dritte Kamera die Ist-Lage des Substrats an der Ablagestation 3.

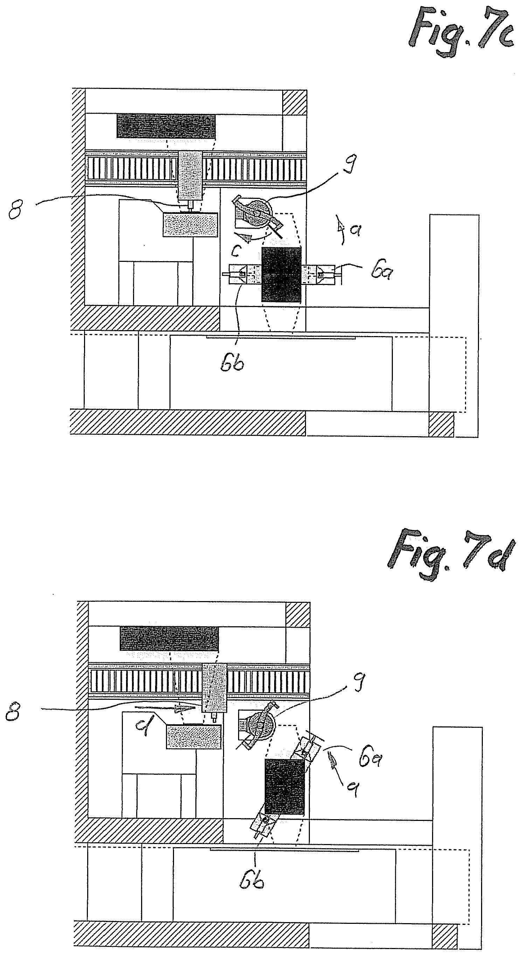

Gemäss Figur 7c hat der Dreharm 23 eine etwa horizontale Position erreicht. Das Sekundärwerkzeug 8 setzt seinen Halbleiterchip an der Ablagestation auf das Substrat ab. Gleichzeitig hat auch die Wendevorrichtung 9 begonnen, sich in Pfeilrichtung c zu drehen, um den vorher empfangenen Chip 1 um 180° zu wenden.

Gemäss Figur 7d wird das Sekundärwerkzeug 8 bereits wieder in Pfeilrichtung d zurückgefahren. Die Wendevorrichtung 9 hat den Wendevorgang noch nicht vollständig beendet und ebenso hat der Dreharm 23 noch nicht wieder seine vertikale Aufnahme- bzw. Abgabeposition erreicht. Die Drehrichtungen des Dreharms und der Wendevorrichtungen verlaufen übrigens stets gegensinnig, jedoch immer in die gleiche Richtung, sodass die beiden Drehkörper ohne miteinander zu kollidieren stets ineinander greifen. Über eine Drehbewegung von jeweils 360° werden somit stets zwei Chips transportiert.

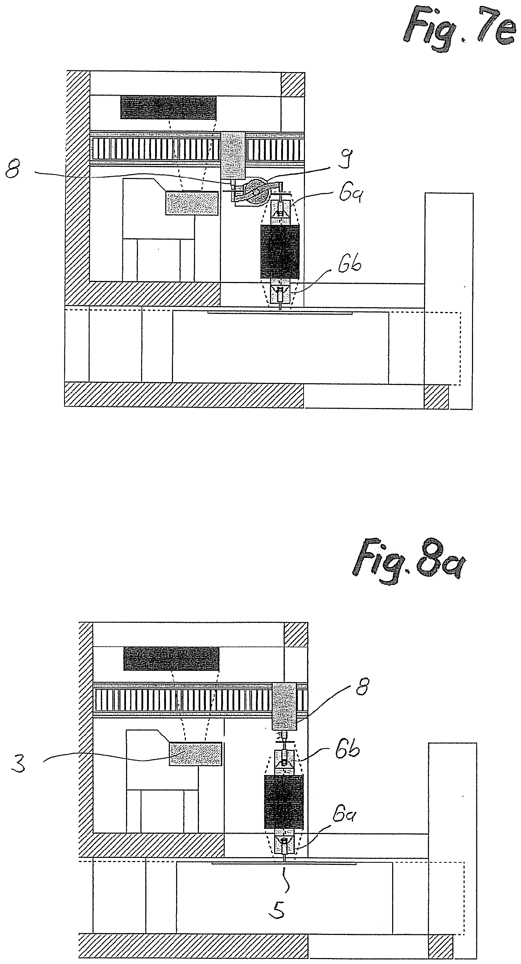

In der Position gemäss Figur 7e hat die Wendevorrichtung 9 eine vollständige Drehung um 180° erreicht. Ebenso der Dreharm 23, der jetzt wiederum in einer vertikalen Position steht. Das erste Primärwerkzeug 6a ist jetzt bereit, seinen vorher aufgenommenen Chip der Wendevorrichtung 9 zu übergeben, während das zweite Primärwerkzeug 6b bereit ist, einen neuen Chip von der Vorratsstation 5 aufzunehmen. Ebenso ist das Sekundärwerkzeug 8 bereit, den nun gewendeten Chip von der Wendevorrichtung zu übernehmen.

Wird eine Ablage des Chips auf das Substrat mit seiner Strukturseite gewünscht (Flipchip-Anwendung), kann die Vorrichtung in einem zweiten Betriebsmodus gefahren werden. Dabei wird die Wendevorrichtung 9 aus einer Betriebsstellung in eine Ruhestellung gebracht. Dies erfolgt dadurch, dass sie auf eine Ebene zurück gezogen wird, welche hinter der Bewegungsebene des Sekundärwerkzeugs 8 liegt. Aus Gründen der besseren Übersichtlichkeit wurde in den Figuren 8a bis 8e die Wendevorrichtung völlig weggelassen, obwohl sie natürlich auch in der Ruhestellung sichtbar bleibt.

Die in den Figuren 8a bis 8e dargestellten Sequenzen entsprechend weitgehend denjenigen, wie sie auch in den Figuren 7a bis 7e dargestellt sind. Gemäss Figur 8a wird vom ersten Primärwerkzeug 6a ein Halbleiterchip von der Vorratsstation 5 aufgenommen, während das zweite Primärwerkzeug 6b einen Halbleiterchip direkt dem Sekundärwerkzeug 8 übergibt. Ersichtlicherweise erfasst das Sekundärwerkzeug 8 den Halbleiterchip jetzt nicht mehr auf der Strukturseite, wie dies in der vorher beschriebenen Betriebsart nach dem Wenden des Chips der Fall war, sondern auf der Auflageseite, auf welcher der Chip vorher auf der Waferfolie haftete.

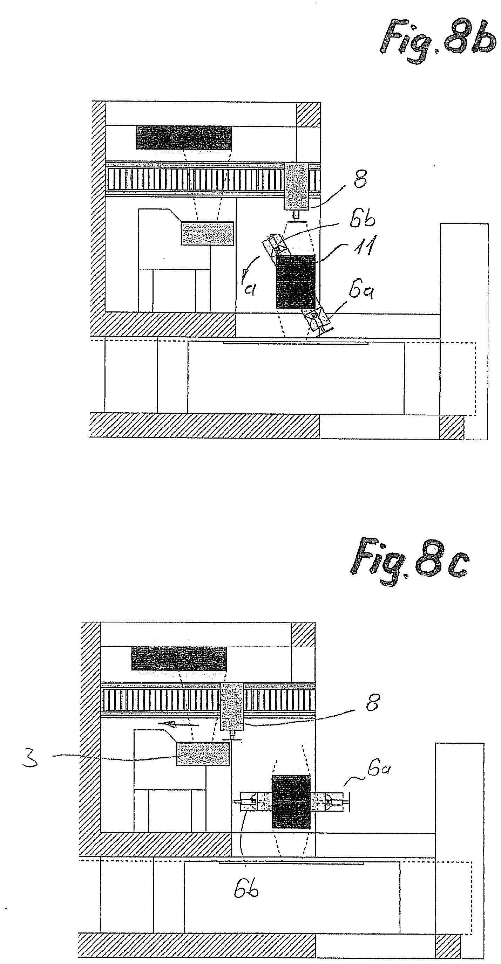

Gemäss Figur 8b beginnt sich der Dreharm 23 in Pfeilrichtung a zu drehen, während das Sekundärwerkzeug 8 immer noch still steht. In dieser Position können die drei Kameras wiederum die jeweilige Ist-Lage erfassen. Im einzelnen bedeutet dies, dass die zweite Kamera 11, die im Non-Flip-Anwendungsfall die Lage des Chips auf der Wendevorrichtung erfasst (Figur 5), jetzt für die Lageerfassung auf dem Sekundärwerkzeug 8 eingesetzt wird. Ersichtlicherweise ist dies ein weiterer Vorteil der bifunktionalen Vorrichtung.

Gemäss Figur 8c hat sich das Sekundärwerkzeug 8 Richtung Ablagestation 3 in Bewegung gesetzt. Das leere zweite Primärwerkzeug 6b bzw. das beladene erste Primärwerkzeug 6a haben einen Weg von 90° zurück gelegt.

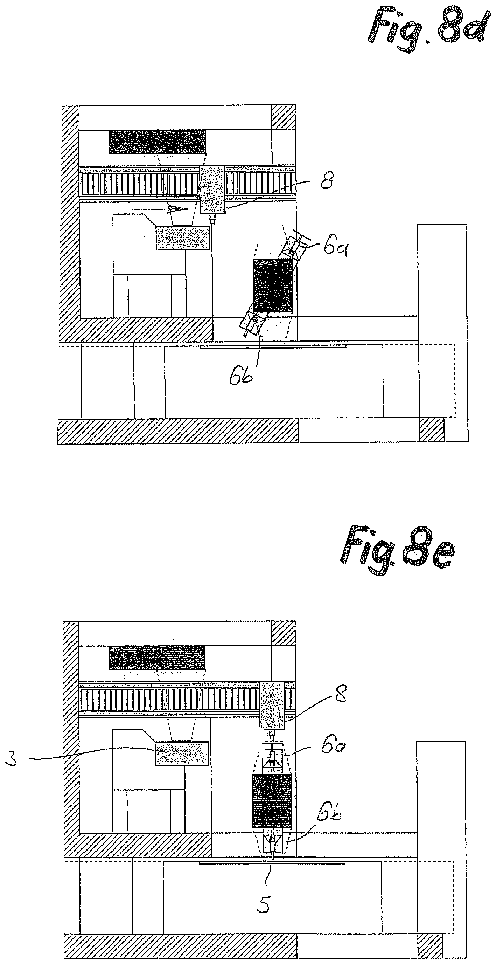

Gemäss Figur 8d hat das Sekundärwerkzeug seinen Chip bereits auf das Substrat abgesetzt und befindet sich wieder auf dem Rückweg in die Aufnahmeposition. Der Dreharm 23 hat seine 180° Drehung noch nicht vollständig beendet.

Gemäss Figur 8e befinden sich die ersten und zweiten Primärwerkzeuge 6a, 6b und das Sekundärwerkzeug 8 exakt auf der gleichen vertikalen Ebene. Das Sekundärwerkzeug 8 ist bereit einen neuen Chip aufzunehmen, der in der Bereitstellungsebene vom ersten Primärwerkzeug 6a bereit gestellt wird. Gleichzeitig ist das zweite Primärwerkzeug 6b bereit, einen neuen Chip von der Vorratsstation bzw. vom Wafertisch aufzunehmen. Der Ablegevorgang beginnt jetzt wieder von vorne.

Die Figur 9 zeigt nochmals eine perspektivische Gesamtdarstellung der beschriebenen Vorrichtung mit dem Maschinengestell 26 und der hier in die Ruheposition abgesenkten Waferkassette 27. Die Ablagestation 3 ist hier als Zufuhrsystem 39 ausgebildet, auf welchem in Pfeilrichtung x Substrate taktweise zugeführt werden können. Ebenfalls sichtbar sind die Wendevorrichtung 9, der Dreharm 23 und die erste Führungsschiene 21 für den Schlitten mit dem Sekundärwerkzeug.

## Patentansprüche

1. Verfahren zum Ablegen von elektronischen Bauteilen, insbesondere Halbleiterchips (1), auf einem Substrat (2) an einer Ablagestation (3), wobei ein mit einer Auflageseite (4) an einer Vorratsstation (5) aufliegendes Bauteil mit einem Primärwerkzeug (6) aufgenommen und durch eine Drehbewegung des Primärwerkzeugs (6) auf eine über der Ebene der Vorratsstation (5) liegende Bereitstellungsebene (7) transportiert wird, und wobei das Bauteil von einem Sekundärwerkzeug (8) in der Bereitstellungsebene (7) übernommen, über das Substrat (2) transportiert und dort abgesetzt wird, **dadurch gekennzeichnet, dass** das Bauteil in der Bereitstellungsebene (7) mittels einer Wendevorrichtung (9) vom Primärwerkzeug (6) abgenommen und derart gewendet und dem Sekundärwerkzeug (8) übergeben wird, dass es wiederum mit der gleichen Auflageseite (4) auf das Substrat (2) abgesetzt wird, und, dass in einem ersten Betriebsmodus die Wendevorrichtung (9) in einer Betriebsstellung arbeitet und dass für einen zweiten Betriebsmodus die Wendevorrichtung (9) in eine Ruhestellung gefahren wird, in welcher das Sekundärwerkzeug (8) das Bauteil direkt vom Primärwerkzeug (6) übernimmt, wobei dieses mit einer von der Auflageseite (4) abgewandten Strukturseite (17) auf das Substrat (2) abgesetzt wird.

2. Verfahren nach Anspruch 1, **dadurch gekennzeichnet, dass** die Ist-Lage des Bauteils auf der Vorratsstation (5) vor der Aufnahme mit einer ersten Überwachungseinrichtung ermittelt wird, und/oder dass die Ist-Lage des Bauteils in der Bereitstellungsebene (7) vor dem Transport zum Substrat (2) mit einer zweiten Überwachungseinrichtung ermittelt wird, und/oder dass die Ist-Lage des Substrats (2) mit einer dritten Überwachungseinrichtung ermittelt wird, wobei Abweichungen zwischen den ermittelten Ist-Werten und einer vorbestimmten Soll-Lage des Bauteils korrigiert werden.

3. Verfahren nach Anspruch 2, **dadurch gekennzeichnet, dass** die Überwachungseinrichtungen Bilderkennungseinrichtungen sind, und die Ermittlung der Ist-Lage mit je einer Bilderkennungseinrichtung immer dann erfolgt, wenn das Primärwerkzeug (6) bzw. das Sekundärwerkzeug (8) das Bildfeld der zu ermittelnden Ist-Lage freigibt.

4. Verfahren nach einem der Ansprüche 1 bis 3, **dadurch gekennzeichnet, dass** wenigstens ein erstes und ein zweites Primärwerkzeug (6a, 6b) derart betätigt werden, dass das erste Primärwerkzeug (6a) ein Bauteil aufnimmt, und das zweite Primärwerkzeug (6b) ein Bauteil an die Wendevorrichtung (9) abgibt.

5. Vorrichtung zum Ablegen von elektronischen Bauteilen, insbesondere Halbleiterchips (1), auf einem Substrat (2) an einer Ablagestation (3), wobei ein mit einer Auflageseite (4) an einer Vorratsstation (5) aufliegendes Bauteil mit einem Primärwerkzeug (6) aufnehmbar ist, das um eine Achse drehbar gelagert ist und mit dem das Bauteil auf eine über der Ebene der Vorratsstation (5) liegende Bereitstellungsebene (7) transportierbar ist, und wobei das Bauteil von einem verschiebbaren Sekundärwerkzeug (8) aus der Bereitstellungsebene (7) übernehmbar, über das Substrat (2) transportierbar und dort absetzbar ist, **dadurch gekennzeichnet, dass** im Bereich der Bereitstellungsebene (7) eine Wendevorrichtung (9) angeordnet ist, mit welcher das Bauteil an der Auflageseite (4) vom Primärwerkzeug (6) abnehmbar ist und derart wendbar und dem Sekundärwerkzeug (8) übergebbar ist, dass es wiederum mit der gleichen Auflageseite (4) auf das Substrat (2) absetzbar ist, und, dass die Wendevorrichtung (9) aus einer Betriebsstellung in eine Ruhestellung verschiebbar ist, wobei in der Ruhestellung das Bauteil direkt in der Bereitstellungsebene (7) vom Primärwerkzeug (6) dem Sekundärwerkzeug (8) übergebbar ist und mit einer der Auflageseite (4) abgewandten Strukturseite (17) auf das Substrat (2) absetzbar ist.

6. Vorrichtung nach Anspruch 5, **dadurch gekennzeichnet, dass** für die Ermittlung der Ist-Lage des Bauteils auf der Vorratsstation (5) vor der Aufnahme eine erste Überwachungseinrichtung vorgesehen ist, und/oder dass für die Ermittlung der Ist-Lage des Bauteils in der Bereitstellungsebene (7) vor dem Transport zum Substrat (2) eine zweite Überwachungseinrichtung vorgesehen ist, und/oder dass für die Ermittlung der Ist-Lage des Substrats (2) eine dritte Überwachungseinrichtung vorgesehen ist, wobei Abweichungen zwischen den ermittelten Ist-Werten und einer vorbestimmten Soll-Lage des Bauteils korrigierbar sind.

7. Vorrichtung nach Anspruch 6, **dadurch gekennzeichnet, dass** die Überwachungseinrichtungen Bilderkennungseinrichtungen sind, welche derart positioniert sind, dass das Bildfeld der zu ermittelnden Ist-Lage in wenigstens einer Betriebslage des Primärwerkzeugs (6) bzw. des Sekundärwerkzeugs (8) vollständig erfassbar ist.

8. Vorrichtung nach Anspruch 6 oder 7, **dadurch gekennzeichnet, dass** die dritte Bilderkennungseinrichtung an einem wenigstens in einer Raumachse verschiebbaren Schlitten gelagert ist.

9. Vorrichtung nach Anspruch 7 oder 8, **dadurch gekennzeichnet, dass** die erste und die zweite Bilderkennungseinrichtung derart angeordnet sind, dass die Erfassung der ihnen zugeordneten Bildfelder von innerhalb des Drehkreises (14) des Primärwerkzeugs (6) aus erfolgt.

10. Vorrichtung nach einem der Ansprüche 5 bis 9, **dadurch gekennzeichnet, dass** ein erstes und ein zweites Primärwerkzeug (6a, 6b) derart miteinander gekoppelt sind, dass mit dem ersten Primärwerkzeug (6a) ein Bauteil aufnehmbar ist, und mit dem zweiten Primärwerkzeug (6b) ein Bauteil an die Wendevorrichtung abgebbar ist.

11. Vorrichtung nach Anspruch 10, **dadurch gekennzeichnet, dass** das erste und das zweite Primärwerkzeug (6a, 6b) bezogen auf die Drehachse vorzugsweise an einem U-förmigen Dreharm (23) diametral einander gegenüberliegend angeordnet sind.

12. Vorrichtung nach Anspruch 11, **dadurch gekennzeichnet, dass** die Wendevorrichtung (9) ein drehbares Doppelarmwerkzeug ist, wobei mit jedem Arm ein Bauteil in der Bereitstellungsebene (7) vom Primärwerkzeug (6) übernehmbar bzw. an das Sekundärwerkzeug (8) übergebbar ist.

13. Vorrichtung nach einem der Ansprüche 5 bis 12, **dadurch gekennzeichnet, dass** das Sekundärwerkzeug (8) an einem linear verschiebbaren Schlitten angeordnet ist.

14. Vorrichtung nach einem der Ansprüche 5 bis 13, **dadurch gekennzeichnet, dass** das Primärwerkzeug (6) sich auf einer Drehebene dreht, welche etwa parallel zur Verschieberichtung des Sekundärwerkzeugs (8) verläuft.

15. Vorrichtung nach einem der Ansprüche 5 bis 14, **dadurch gekennzeichnet, dass** die Ablagestation (3) als Zuführsystem (39) für den vorzugsweise linearen Durchlauf einer Mehrzahl von Substraten (2) ausgebildet ist.

16. Vorrichtung nach einem der Ansprüche 5 bis 15, **dadurch gekennzeichnet, dass** die Wendevorrichtung (9) als Pufferstation für die vorübergehende Aufnahme einer Mehrzahl von Bauteilen ausgebildet ist.

17. Vorrichtung nach einem der Ansprüche 5 bis 16, **dadurch gekennzeichnet, dass** neben der Vorratsstation (5) eine Wafer-kassette (27) angeordnet ist, welche zum Laden von Waferframes (20) auf die Vorratsstation (5) in verschiedene Ladepositionen bewegbar ist, in denen die Vorratsstation (5) und die Waferkassette (27) wenigstens teilweise auf der gleichen Ebene angeordnet sind und dass die Waferkassette (27) in eine Ruheposition bewegbar ist, in welcher die Vorratsstation (5) zum Abarbeiten eines geladenen Waferframes (20) wenigstens teilweise in der horizontalen Arbeitsebene über die Waferkassette (27) verschiebbar ist.

18. Vorrichtung nach einem der Ansprüche 5 bis 17, **dadurch gekennzeichnet, dass** im Bereich des Drehkreises (14) des Primärwerkzeugs (6), eine oder mehrere Zwischenablagestationen (40) angeordnet sind, an denen ein Bauteil insbesondere vor der Übergabe an die Wendevorrichtung (9) bzw. vor der Übergabe an das Sekundärwerkzeug (8) vorübergehend ablegbar ist.

## Claims

1. A method for the placement of electronic components, in particular semiconductor chips (1), on a substrate (2) at a placement station (3), in which case a component bearing by a bearing side (4) at a supply station (5) is picked up by means of a primary tool (6) and is transported to a provision plane (7) lying above the plane of the supply station (5) by means of a rotational movement of the primary tool, and wherein the component is accepted by a secondary tool (8) in the provision plane (7), transported over the substrate (2) and deposited there, **characterized in that** the component is taken from the primary tool (6) in the provision plane (7) by means of a turning apparatus (9) and is turned and transferred to the secondary tool (8) in such a way that it is deposited onto the substrate (2) once again by the same bearing side (4), and that, in a first operating mode the turning apparatus (9) works in an operating position, and **in that** for a second operating mode the turning apparatus (9) is brought to a rest position, in which the secondary tool (8) accepts the component directly from the primary tool (6), said component being deposited onto the substrate (2) by the structure side (17) remote from the bearing side (4).

2. The method as claimed in claim 1, **characterized in that** the actual position of the component on the supply station (5) prior to the pick-up is determined by means of a first monitoring device, and/or **in that** the actual position of the component in the provision plane (7) prior to the transport to the substrate (2) is determined by means of a second monitoring device, and/or **in that** the actual position of the substrate (2) is determined by means of a third monitoring device, deviations between the actual values determined and a predetermined desired position of the component being corrected.

3. The method as claimed in claim 2, **characterized in that** the monitoring devices are image recognition devices and the actual position is determined by means of a respective image recognition device whenever the primary tool (6) or the secondary tool (8) clears the image field of the actual position to be determined.

4. The method as claimed in one of claims 1 to 3, **characterized in that** at least a first and a second primary tool (6a, 6b) are actuated in such a way that a first primary tool (6a) picks up a component, and a second primary tool (6b) delivers a component to the turning apparatus (9).

5. An apparatus for the placement of electronic components, in particular semiconductor chips (1), on a substrate (2) at a placement station (3), in which case a component bearing at a supply station (5) by a bearing side (4) can be picked up by means of a primary tool (6), which is mounted such that it can be rotated about an axis and by means of which the component can be transported to a provision plane (7) lying above the plane of the supply station (5), and wherein the component can be accepted from the provision plane (7) by a displaceable secondary tool (8), can be transported over the substrate (2) and can be deposited there, **characterized in that** a turning apparatus (9) is arranged in the region of the provision plane (7), by means of which turning apparatus the component can be taken from the primary tool (6) at the bearing side (4) and can be turned and can be transferred to the secondary tool (8) in such a way that it can be deposited onto the substrate (2) once again by the same bearing side (4), and **in that** the turning apparatus (9) can be displaced from an operating position into a rest position, wherein in the rest position, the component can be transferred to the secondary tool (8) from the primary tool (6) directly in the provision plane (7) and can be deposited onto the substrate (2) by the structure side (17) remote from the bearing side (4).

6. The apparatus as claimed in claim 5, **characterized in that** a first monitoring device is provided for determining the actual position of the component on the supply station prior to the pick-up, and/or **in that** a second monitoring device is provided for determining the actual position of the component in the provision plane (7) prior to the transport to the substrate (2), and/or **in that** a third monitoring device is provided for determining the actual position of the substrate (2), it being possible to correct deviations between the actual values determined and a predetermined desired position of the component.

7. The apparatus as claimed in claim 6, **characterized in that** the monitoring devices are image recognition devices which are positioned in such a way that the image field of the actual position to be determined can be completely captured in at least one operating position of the primary tool (6) or of the secondary tool (8).

8. The apparatus as claimed in claim 6 or 7, **characterized in that** the third image recognition device is mounted on a slide that can be displaced at least in one spatial axis.

9. The apparatus as claimed in claim 7 or 8, **characterized in that** the first and second image recognition devices are arranged in such a way that the image fields assigned to them are captured from within the rotational circle (14) of the primary tool (6).

10. The apparatus as claimed in one of claims 5 to 9, **characterized in that** a first and a second primary tool (6a, 6b) are coupled to one another in such a way that a component can be picked up by means of a first primary tool (6a), and a component can be delivered to the turning apparatus by means of a second primary tool (6b).

11. The apparatus as claimed in claim 10, **characterized in that** the first and second primary tools (6a, 6b) are arranged diametrically opposite one another relative to the axis of rotation preferably on a U-shaped rotary arm (23).

12. The apparatus as claimed in claim 11, **characterized in that** the turning apparatus (9) is a rotatable double arm tool, in which case with each arm it is possible for a component to be accepted from the primary tool (6) in the provision plane (7) and to be transferred to the secondary tool (8), respectively.

13. The apparatus as claimed in one of claims 5 to 12, **characterized in that** the secondary tool (8) is arranged on a linearly displaceable slide.

14. The apparatus as claimed in one of claims 5 to 13, **characterized in that** the primary tool (6) rotates on a rotational plane which runs approximately parallel to the displacement direction of the secondary tool (8).

15. The apparatus as claimed in one of claims 5 to 14, **characterized in that** the placement station (3) is embodied as a feed system (39) for the preferably linear passage of a plurality of substrates (2).

16. The apparatus as claimed in one of claims 5 to 15, **characterized in that** the turning apparatus (9) is embodied as a buffer station for temporarily receiving a plurality of components.

17. The apparatus as claimed in one of claims 5 to 16, **characterized in that** a wafer cassette (27) is arranged alongside the supply station (5) and can be moved, for the purpose of loading wafer frames (20) onto the supply station (5), into different loading positions in which the supply station (5) and the wafer cassette (27) are at least partly arranged on the same plane, and **in that** the wafer cassette (27) can be moved into a rest position in which the supply station (5), for processing a loaded wafer frame (20), can be displaced at least partly in the horizontal working plane over the wafer cassette (27).

18. The apparatus as claimed in one of claims 5 to 17, **characterized in that** one or a plurality of intermediate placement stations (40) at which a component can be placed temporarily in particular prior to the transfer to the turning apparatus (9) or prior to the transfer to the secondary tool (8) are arranged in the region of the rotational circle (14) of the primary tool (6).

## Revendications

1. Procédé, destiné à déposer des composants électroniques, notamment des puces à semi-conducteurs (1) sur un substrat (2) dans un poste de dépose (3), un composant qui repose par une face d'appui (4) sur un poste de réserve (5) étant repris par un outil primaire (6) et par un déplacement en rotation de l'outil primaire (6), étant transporté dans un plan de mise à disposition (7) situé au-dessus du plan du poste de réserve (5), et le composant étant repris par un outil secondaire (8) dans le plan de mise à disposition (7), transporté au-dessus du substrat (2) et y étant déposé, **caractérisé en ce que** dans le plan de mise à disposition (7), le composant est repris à partir de l'outil primaire (6) au moyen d'un dispositif de retournement (9) et retourné et transféré à l'outil secondaire (8) de sorte à être de nouveau déposé avec la même face d'appui (4) sur le substrat (2) et **en ce que** dans un premier mode de fonctionnement, le dispositif de retournement (9) travaille dans une position de service et **en ce que** pour un deuxième mode de fonctionnement, le dispositif de retournement (9) est amené dans une position de repos dans laquelle l'outil secondaire (8) reprend le composant directement à partir de l'outil primaire (6), celui-ci étant déposé par une face structurée (17) opposée à la face d'appui (4) sur le substrat (2) .

2. Procédé selon la revendication 1, **caractérisé en ce que** la position réelle du composant sur le poste de réserve (5) avant la reprise est déterminée par un premier système de supervision, et/ou **en ce que** la position réelle du composant dans le plan de mise à disposition (7) avant le transport vers le substrat (2) est déterminée avec un deuxième système de supervision, et/ou **en ce que** la position réelle du substrat (2) est déterminée avec un troisième système de supervision, des écarts entre les valeurs réelles déterminée et une valeur de consigne prédéfinie du composant étant corrigés.

3. Procédé selon la revendication 2, **caractérisé en ce que** les systèmes de supervision sont des systèmes de reconnaissance d'images et **en ce que** la détermination de la position réelle par chaque fois un système de reconnaissance d'images s'effectue chaque fois lorsque l'outil primaire (6) ou l'outil secondaire (8) libère le champ d'image de la position réelle qu'il s'agit de déterminer.

4. Procédé selon l'une quelconque des revendications 1 à 3, **caractérisé en ce qu'**au moins un premier et un deuxième outils primaires (6a, 6b) sont actionnés de telle sorte que le premier outil primaire (6a) reprenne un composant et le deuxième outil primaire (6b) restitue un composant au dispositif de retournement (9).

5. Dispositif, destiné à déposer des composants électroniques, notamment des puces à semi-conducteurs (1) sur un substrat (2) dans un poste de dépose (3), un composant qui repose par une face d'appui (4) sur un poste de réserve (5) étant susceptible d'être repris par un outil primaire (6) qui est logé de manière rotative autour d'un axe et à l'aide duquel le composant est transportable vers un plan de mise à disposition (7) situé au-dessus du poste de réserve (5), et le composant étant susceptible d'être repris hors du plan de mise à disposition (7) par un outil secondaire (8) translatable, d'être transporté au-dessus du substrat (2) et d'y être déposé, **caractérisé en ce que** dans la région du plan de mise à disposition (7) est placé un dispositif de retournement (9), à l'aide duquel le composant est susceptible d'être repris sur la face d'appui (4) par l'outil primaire (6) et d'être retourné et transféré à l'outil secondaire (8) de sorte à pouvoir être déposé de nouveau avec la même face d'appui (4) sur le substrat (2) et **en ce que** le dispositif de retournement (9) est translatable d'une position de service dans une position de repos, dans la position de repos, le composant étant susceptible d'être transféré directement dans le plan de mise à disposition (7) de l'outil primaire (6) à l'outil secondaire (8) et d'être déposé par une face structurée (17) opposée à la face d'appui (4) sur le substrat (2).

6. Dispositif selon la revendication 5, **caractérisé en ce que** pour la détermination de la position réelle du composant sur le poste de réserve (5) avant la reprise, il est prévu un premier système de supervision et/ou **en ce que** pour la détermination de la position réelle du composant dans le plan de mise à disposition (7) avant le transport vers le substrat (2), il est prévu un deuxième système de supervision et/ou **en ce que** pour la détermination de la position réelle du substrat (2), il est prévu un troisième système de supervision, des écarts entre les valeurs réelles et une valeur de consigne prédéfinie du composant étant susceptibles d'être corrigés.

7. Dispositif selon la revendication 6, **caractérisé en ce que** les systèmes de supervision sont des systèmes de reconnaissance d'images qui sont positionnés de telle sorte que le champ d'image de la position réelle qu'il s'agit de déterminer puisse être totalement détecté dans au moins une position de service de l'outil primaire (6) ou de l'outil secondaire (8).

8. Dispositif selon la revendication 6 ou 7, **caractérisé en ce que** le troisième système de reconnaissance d'images est logé sur un chariot translatable au moins dans un axe spatial.

9. Dispositif selon la revendication 7 ou 8, **caractérisé en ce que** le premier et le deuxième systèmes de reconnaissance d'images sont placés de telle sorte que la détection des champs d'image qui leur sont affectés s'effectue à partir de l'intérieur du cercle de rotation (14) de l'outil primaire (6).

10. Dispositif selon l'une quelconque des revendications 5 à 9, **caractérisé en ce qu'**un premier et un deuxième outils primaires (6a, 6b) sont accouplés l'un à l'autre de telle sorte qu'avec le premier outil primaire (6a), un composant puisse être repris, et avec le deuxième outil primaire (6b), un composant puisse être restitué au dispositif de retournement.

11. Dispositif selon la revendication 10, **caractérisé en ce que** le premier et le deuxième outils primaires (6a, 6b) sont placés en étant diamétralement opposés en rapport à l'axe de rotation, de préférence sur un bras rotatif (23) en forme de U.

12. Dispositif selon la revendication 11, **caractérisé en ce que** le dispositif de retournement (9) est un outil rotatif à double bras, avec chaque bras, un composant pouvant être repris dans le plan de mise à disposition (7) par l'outil primaire (6) ou transféré à l'outil secondaire (8).

13. Dispositif selon l'une quelconque des revendications 5 à 12, **caractérisé en ce que** l'outil secondaire (8) est placé sur un chariot linéairement translatable.

14. Dispositif selon l'une quelconque des revendications 5 à 13, **caractérisé en ce que** l'outil primaire (6) tourne dans un plan de rotation qui s'écoule approximativement à la parallèle de la direction de translation de l'outil secondaire (8).

15. Dispositif selon l'une quelconque des revendications 5 à 14, **caractérisé en ce que** le poste de dépose (3) est conçu en tant que système d'alimentation (39) pour le passage de préférence linéaire d'une pluralité de substrats (2).

16. Dispositif selon l'une quelconque des revendications 5 à 15, **caractérisé en ce que** le dispositif de retournement (9) est conçu en tant que poste tampon pour la réception provisoire d'une pluralité de composants.

17. Dispositif selon l'une quelconque des revendications 5 à 16, **caractérisé en ce qu'**à côté du poste de réserve (5) est placée une cassette à tranches (27), qui pour le chargement de trames de tranches (20) sur le poste de réserve (5) est mobile dans différentes positions de chargement dans lesquelles le poste de réserve (5) et la cassette à tranches (27) sont placés au moins partiellement dans le même plan et **en ce que** la cassette à tranches (27) est mobile dans une position de repos dans laquelle, pour traiter une trame de tranches (20) chargée, le poste de réserve (5) est translatable au moins partiellement dans le plan de travail horizontal au-dessus de la cassette à tranches (27) .

18. Dispositif selon l'une quelconque des revendications 5 à 17, **caractérisé en ce que** dans la région du cercle de rotation (14) de l'outil primaire (6) est/sont placé(s)un ou plusieurs poste(s) d'entreposage (40) sur lequel/lesquels un composant peut être déposé provisoirement, notamment avant le transfert au dispositif de retournement (9) ou avant le transfert à l'outil secondaire (8).
